# EUROPEAN PATENT APPLICATION

(11) **EP 4 521 466 A1**
(43) Date of publication of application: **12.03.2025**
(21) Application number: 23810761.9
(22) Date of filing: 28.04.2023
(51) Int. Cl.: H01L 27/12, H01L 21/77

(54) **ARRAY SUBSTRATE, MANUFACTURING METHOD THEREFOR, AND DISPLAY APPARATUS**

(30) Priority: 27.05.2022 CN 202210590935
(71) Applicant: Boe Technology Group Co., Ltd., Beijing 100015 (CN); Hefei Xinsheng Optoelectronics Technology Co., Ltd., Hefei, Anhui 230012 (CN)
(72) Inventor: WANG, Ming, Beijing 100176 (CN); ZHANG, Dacheng, Beijing 100176 (CN)
(74) Representative: Santarelli
(86) International application number: PCT/CN2023/091472
(87) International publication number: WO 2023/226688

(57) **Abstract**

Provided in the present disclosure are an array substrate, a manufacturing method therefor, and a display apparatus. The array substrate comprises: a substrate structure; an active layer on the substrate structure; a patterned first insulation layer on the side of the active layer away from the substrate structure, the first insulation layer being provided with a first through hole exposing part of the active layer; a first conductive layer in the first through hole and in contact with the active layer; and a first connection member on the side of the first insulation layer away from the substrate structure, the first connection member being in contact with the first conductive layer, and the first connection member covering a first portion of the first conductive layer and not covering a second portion of the first conductive layer. The present disclosure can reduce the possibility of occurrence of missing portions of an active layer, thereby improving the performance of an array substrate and a display apparatus formed by same.

## Description

### CROSS-REFERENCE TO RELATED APPLICATIONS

The present application is based on and claims priority to China Patent Application No. 202210590935.4 filed on May 27, 2022, the disclosure of which is incorporated by reference herein in its entirety.

### TECHNICAL FIELD

The present disclosure relates to the field of display technology, and in particular, to an array substrate, a manufacturing method thereof, and a display apparatus.

### BACKGROUND

At present, OLED (Organic Light-Emitting Diode) technology is becoming more and more mature. In some OLED display panels, the array substrate may be masked five times (which may be referred to as 5 Mask). During the process of manufacturing the array substrate, it is necessary to manufacture a TFT (Thin Film Transistor) transistor.

### SUMMARY

According to an aspect of the present disclosure, an array substrate is provided. The array substrate comprises: a substrate structure; an active layer on the substrate structure; a first insulating layer on a side of the active layer away from the substrate structure, wherein the first insulating layer is patterned and the first insulating layer is provided with a first through hole exposing a portion of the active layer; a first conductive layer in the first through hole and in contact with the active layer; and a first connection member on a side of the first insulating layer away from the substrate structure, wherein the first connection member is in contact with the first conductive layer, and the first connection member covers a first portion of the first conductive layer and does not cover a second portion of the first conductive layer.

In some embodiments, the first insulating layer is further provided with a second through hole exposing another portion of the active layer; and the array substrate further comprises: a second conductive layer in the second through hole; a second connection member electrically connected to the second conductive layer; and a gate on a side of the first insulating layer away from the active layer; wherein the second connection member is in a same layer as the gate, and the first connection member and the second connection member are isolated from the gate.

In some embodiments, the substrate structure comprises: a base substrate; a light shielding layer and a third conductive layer on the base substrate, wherein an orthographic projection of the light shielding layer on the base substrate at least partially overlaps with an orthographic projection of the active layer on the base substrate, wherein the third conductive layer covers the light shielding layer, or the light shielding layer covers the third conductive layer; and a buffer layer between the third conductive layer and the active layer.

In some embodiments, an orthographic projection of the first conductive layer on the base substrate at least partially overlaps with the orthographic projection of the light shielding layer on the base substrate.

In some embodiments, the second through hole further exposes a portion of the buffer layer; and the second conductive layer comprises: a third portion on a surface of the active layer and a fourth portion on a surface of the buffer layer.

In some embodiments, materials of the first conductive layer, the second conductive layer and the third conductive layer comprise a transparent conductive material.

In some embodiments, a thickness of the third conductive layer is greater than a thickness of the second conductive layer, and the thickness of the second conductive layer is equal to a thickness of the first conductive layer.

In some embodiments, a thickness of the first conductive layer is greater than a thickness of the active layer.

In some embodiments, an area of an overlapping portion of the first connection member and the first conductive layer is less than an area of an overlapping portion of the second connection member and the second conductive layer.

In some embodiments, the first insulating layer comprises a gate insulating layer below the gate; and the active layer comprises: a first conductor region electrically connected to the first connection member, a second conductor region electrically connected to the second connection member, and a channel region between the first conductor region and the second conductor region, wherein the channel region is flush with an edge of the gate insulating layer.

In some embodiments, a width of an overlapping portion of the first connection member and the first conductive layer along a direction from the first connection member to the gate is less than a distance between an edge of the first conductive layer and the channel region.

In some embodiments, an area of the first conductor layer is greater than an area of an overlapping portion of the first connection member and the first conductive layer.

In some embodiments, an area of the first conductor layer is less than an area of the channel region.

**In** some embodiments, a width of an overlapping portion of the first conductive layer and the active layer along a direction from the first connection member to the gate is less than a width of an overlapping portion of the second conductive layer and the active layer along the direction from the first connection member to the gate.

In some embodiments, a distance between the first conductive layer and the gate is greater than a width of an overlapping portion of the first connection member and the first conductive layer along a direction from the first connection member to the gate, and the width of the overlapping portion of the first connection member and the first conductive layer along the direction from the first connection member to the gate is greater than a width of the second portion of the first conductive layer along the direction from the first connection member to the gate.

In some embodiments, the array substrate further comprises: a second insulating layer covering the first connection member, the second connection member and the gate; a planarization layer on a side of the second insulating layer away from the substrate structure; a first electrode layer and a pixel defining layer on a side of the planarization layer away from the substrate structure, wherein the first electrode layer is electrically connected to the second connection member, and the pixel defining layer is provided with a first opening exposing at least a portion of the first electrode layer; a light emitting layer at least located in the first opening; and a second electrode layer electrically connected to the light emitting layer.

In some embodiments, a width of an overlapping portion between an orthographic projection of the second conductive layer on the base substrate and an orthographic projection of the third conductive layer on the base substrate along a direction from the first connection member to the gate is less than a width of an overlapping portion between the orthographic projection of the second conductive layer on the base substrate and an orthographic projection of the first electrode layer on the base substrate along the direction from the first connection member to the gate.

In some embodiments, a width of an overlapping portion between an orthographic projection of the second conductive layer on the base substrate and an orthographic projection of the third conductive layer on the base substrate along a direction from the first connection member to the gate is less than a width of an overlapping portion between the orthographic projection of the third conductive layer on the base substrate and an orthographic projection of the first electrode layer on the base substrate along the direction from the first connection member to the gate.

According to another aspect of the present disclosure, an array substrate is provided. The array substrate comprises: a substrate structure; and a thin film transistor on the substrate structure, the thin film transistor comprising: an active layer on the substrate structure; a first insulating layer on a side of the active layer away from the substrate structure, wherein the first insulating layer is patterned and the first insulating layer is provided with a first through hole exposing a portion of the active layer; a first conductive layer in the first through hole and in contact with the active layer; and a first connection member, a second connection member and a gate on a side of the first insulating layer away from the substrate structure, wherein the first connection member is in contact with the first conductive layer, the first connection member, the second connection member and the gate are in a same layer and isolated from each other, and the gate is between the first connection member and the second connection member; wherein the active layer comprises: a first conductor region electrically connected to the first connection member, a second conductor region electrically connected to the second connection member and a channel region between the first conductor region and the second conductor region, wherein the channel region is below the gate; the first conductive layer comprises a first portion away from the gate and a second portion close to the gate, the first portion is completely covered by the first connection member, the second portion is not covered by the first connection member, and an orthographic projection of the first conductive layer on the substrate structure is inside an orthographic projection of the active layer on the substrate structure.

In some embodiments, a width of the second portion along a direction from the first connection member to the gate is less than a width of the first portion along the direction from the first connection member to the gate.

In some embodiments, a width of the second portion along a direction from the first connection member to the gate is less than a width of the channel region along the direction from the first connection member to the gate.

In some embodiments, a thickness of the second portion is less than a thickness of the first portion.

In some embodiments, the width of the first portion is 2 to 5 times the width of the second portion.

In some embodiments, the active layer further comprises a semiconductor region on a side of the first conductor region away from the channel region, wherein the width of the second portion along the direction from the first connection member to the gate is less than a width of the semiconductor region along the direction from the first connection member to the gate.

According to another aspect of the present disclosure, a display apparatus is provided. The display apparatus comprises the array substrate described previously.

According to another aspect of the present disclosure, a manufacturing method for an array substrate is provided. The manufacturing method comprises: forming an active layer on a substrate structure; forming a first insulating layer on a side of the active layer away from the substrate structure, wherein the first insulating layer is patterned and the first insulating layer is provided with a first through hole exposing a portion of the active layer; performing a first conductive treatment on the portion of the active layer exposed; forming a first conductive layer in the first through hole, wherein the first conductive layer is in contact with the active layer; forming a connection material layer on a side of the first insulating layer away from the substrate structure by a deposition process; patterning the connection material layer by using a patterned mask layer to form a first connection member, wherein the first connection member is in contact with the first conductive layer, and the first connection member covers a first portion of the first conductive layer and does not cover a second portion of the first conductive layer; etching a first insulating layer by using the patterned mask layer and by a self-alignment process to enlarge the first through hole, wherein the first through hole enlarged exposes another portion of the active layer; and performing a second conductive treatment on the another portion of the active layer exposed.

Other features and advantages of the present disclosure will become apparent from the following detailed description of exemplary embodiments of the present disclosure with reference to the accompanying drawings.

### BRIEF DESCRIPTION OF THE ACCOMPANYING DRAWINGS

The accompanying drawings which constitute a part of this specification, describe the embodiments of the present disclosure, and together with this specification, serve to explain the principles of the present disclosure.

The present disclosure may be more explicitly understood from the following detailed description with reference to the accompanying drawings, in which:
Fig. 1 is a schematic cross-sectional view showing an array substrate according to an embodiment of the present disclosure;
Fig. 2 is a schematic cross-sectional view showing an array substrate according to another embodiment of the present disclosure;
Fig. 3 is an enlarged schematic view schematically showing the array substrate in Fig. 1 at block 201;
Fig. 4 is a top view schematically showing a partial structure of an array substrate according to an embodiment of the present disclosure;
Fig. 5 is a flow chart showing a manufacturing method for an array substrate according to an embodiment of the present disclosure;
Figs. 6A to 6I are schematic cross-sectional views showing structures at several stages during a manufacturing process for an array substrate according to some embodiments of the present disclosure;
Fig. 7 is a schematic cross-sectional view showing a structure at one stage during a manufacturing process for an array substrate according to another embodiment of the present disclosure;
Fig. 8 is a schematic cross-sectional view showing a structure at one stage during a manufacturing process for an array substrate according to another embodiment of the present disclosure;
Figs. 9A to 9C are schematic cross-sectional views showing structures at several stages during a manufacturing process for an array substrate according to other embodiments of the present disclosure;
Figs. 10A to 10C are schematic cross-sectional views showing structures at several stages during a manufacturing process for an array substrate according to other embodiments of the present disclosure.

It should be understood that the dimensions of various parts shown in the accompanying drawings are not drawn according to actual proportional relations. In addition, the same or similar components are denoted by the same or similar reference signs.

### DETAILED DESCRIPTION

Various exemplary embodiments of the present disclosure will now be described in detail in conjunction with the accompanying drawings. The description of the exemplary embodiments is merely illustrative and is in no way intended as a limitation to the present disclosure, its application or use. The present disclosure may be implemented in many different forms, which are not limited to the embodiments described herein. These embodiments are provided to make the present disclosure thorough and complete, and fully convey the scope of the present disclosure to those skilled in the art. It should be noticed that: relative arrangement of components and steps, material composition, numerical expressions, and numerical values set forth in these embodiments, unless specifically stated otherwise, should be explained as merely illustrative, and not as a limitation.

The use of the terms "first", "second" and similar words in the present disclosure do not denote any order, quantity or importance, but are merely used to distinguish between different parts. A word such as "comprise", "include", or the like means that the element before the word covers the element(s) listed after the word without excluding the possibility of also covering other elements. The terms "up", "down", "left", "right", or the like are used only to represent a relative positional relationship, and the relative positional relationship may be changed correspondingly if the absolute position of the described object changes.

In the present disclosure, when it is described that a particular device is located between the first device and the second device, there may be an intermediate device between the particular device and the first device or the second device, and alternatively, there may be no intermediate device. When it is described that a particular device is connected to other devices, the particular device may be directly connected to the other devices without an intermediate device, and alternatively, may not be directly connected to the other devices but with an intermediate device.

All the terms (comprising technical and scientific terms) used in the present disclosure have the same meanings as understood by those skilled in the art of the present disclosure unless otherwise defined. It should also be understood that terms as defined in general dictionaries, unless explicitly defined herein, should be interpreted as having meanings that are consistent with their meanings in the context of the relevant art, and not to be interpreted in an idealized or extremely formalized sense.

Techniques, methods, and apparatus known to those of ordinary skill in the relevant art may not be discussed in detail, but where appropriate, these techniques, methods, and apparatuses should be considered as part of this specification.

The inventors of the present disclosure have found that, in the related art, during the process of forming a TFT of an array substrate, the active layer is etched twice in an region where the source or the drain is in lap joint with the active layer, which resulted in that the active layer is present with a missing portion. This results in a short conduction channel in the region where the source or the drain is in lap joint with the active layer, so that it is possible to limit the current flowing capability, and it is likely to lead to poor contact and affect the performance of a display product.

In view of this, an embodiment of the present disclosure provides an array substrate to reduce the possibility that the active layer is present with a missing portion.

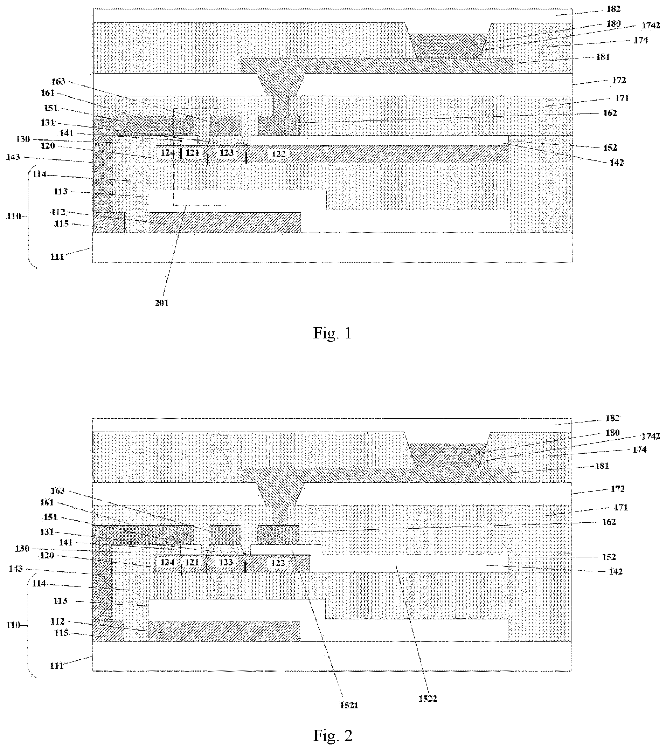

Fig. 1 is a schematic cross-sectional view showing an array substrate according to an embodiment of the present disclosure.

As shown in Fig. 1, the array substrate comprises a substrate structure 110.

As shown in Fig. 1, the array substrate further comprises an active layer 120 on the substrate structure 110. For example, a material of the active layer comprises a semiconductor material such as IGZO (indium gallium zinc oxide).

As shown in Fig. 1, the array substrate further comprises a patterned first insulating layer 130 on a side of the active layer 120 away from the substrate structure. The first insulating layer 130 is provided with a first through hole 141 exposing a portion of the active layer 120. The first insulating layer 130 covers the active layer 120. For example, a material of the first insulating layer comprises an inorganic insulating material (for example, silicon dioxide or silicon nitride).

As shown in Fig. 1, the array substrate further comprises a first conductive layer 151 in the first through hole 141 and in contact with the active layer 120. In some embodiments, a material of the first conductive layer comprises a metal material. For example, the material of the first conductive layer comprises a transparent conductive material. For example, the transparent conductive material comprises ITO (Indium Tin Oxide), IZO (Indium Zinc Oxide), or the like. Here, the first conductive layer is made of the transparent conductive material, which can improve the light transmittance of the array substrate.

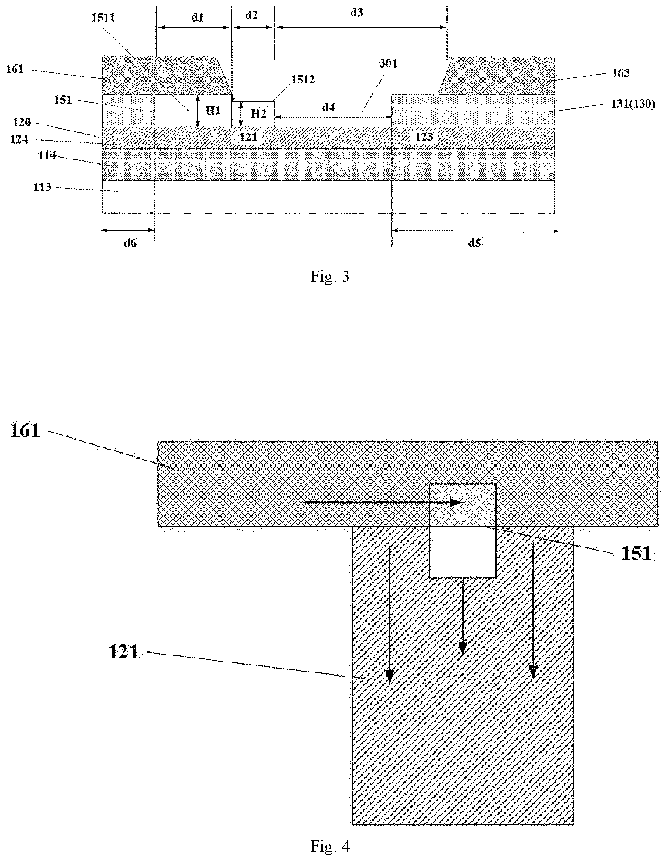

As shown in Fig. 1, the array substrate further comprises a first connection member 161 on a side of the first insulating layer 130 away from the substrate structure 110. The first connection member 161 is in contact with the first conductive layer 151. A material of the first connection member 161 comprises a metal material such as copper or the like. For example, the first connection member is a source or a drain. The first connection member 161 covers a first portion of the first conductive layer 151 and does not cover a second portion of the first conductive layer 151 (described later in conjunction with Fig. 3).

So far, an array substrate according to some embodiments of the present disclosure is provided. The array substrate comprises: a substrate structure; an active layer on the substrate structure; a patterned first insulating layer on a side of the active layer away from the substrate structure, wherein the first insulating layer is provided with a first through hole exposing a portion of the active layer; a first conductive layer in the first through hole and in contact with the active layer; and a first connection member on a side of the first insulating layer away from the substrate structure, wherein the first connection member is in contact with the first conductive layer, and the first connection member covers a first portion of the first conductive layer and does not cover a second portion of the first conductive layer. In this embodiment, since the first conductive layer is formed in the first through hole of the first insulating layer, the first conductive layer can protect a portion of the active layer below the first conductive layer to a certain extent during the manufacturing process, thereby reducing the possibility that the active layer has a missing portion, and further improving the performance of the array substrate and the display apparatus formed by the array substrate.

As shown in Fig. 1, the first insulating layer 130 is further provided with a second through hole 142 exposing another portion of the active layer 120.

In some embodiments, as shown in Fig. 1, the array substrate further comprises a second conductive layer 152 in the second through hole 142. The second conductive layer 152 fills the second through hole 142. For example, a material of the second conductive layer comprises a transparent conductive material. For example, the transparent conductive material comprises: ITO or IZO or the like. Here, the second conductive layer is made of the transparent conductive material, which can improve the light transmittance of the array substrate.

Similar to the first conductive layer previously, the second conductive layer can protect a portion of the active layer below the second conductive layer, thereby reducing the possibility that the active layer is present with a missing portion, and further improving the performance of the array substrate and the display apparatus formed by the array substrate.

In some embodiments, as shown in Fig. 1, a width of an overlapping portion of the first conductive layer 151 and the active layer 120 along a direction from the first connection member to the gate is less than a width of an overlapping portion of the second conductive layer 152 and the active layer 120 along the direction from the first connection member to the gate. In other words, the second conductive layer 152 is manufactured to be relatively large. For example, an area or width of the second conductive layer 152 (that is, a transverse dimension shown in the sectional view) is greater than an area or width of the first conductive layer 151. In this way, the second conductive layer may further serve as an electrode plate of a capacitor. This is beneficial to the formation of a transparent capacitor structure and the improvement of capacitance and conductivity.

In some embodiments, as shown in Fig. 1, the array substrate further comprises a second connection member 162 electrically connected to the second conductive layer 152. The second connection member 162 is in contact with the second conductive layer 152. A material of the second connection member 162 comprises a metal material such as copper or the like. The second connection member may be a source or a drain. For example, the first connection member 161 is the source, and the second connection member 162 is the drain. For another example, the first connection member 161 is the drain, and the second connection member 162 is the source.

In some embodiments, as shown in Fig. 1, the array substrate further comprises a gate 163 on a side of the first insulating layer 130 away from the active layer 120. A material of the gate 163 comprises a metal material such as copper or the like.

As shown in Fig. 1, the second connection member 162 is in a same layer as the gate 163. The first connection member 161 is also in a same layer as the gate 163. The first connection member 161 and the second connection member 162 are both isolated from the gate 163. The gate 163 is between the first connection member 161 and the second connection member 162.

It is to be noted that, "the same layer" refers to a layer structure formed using the same film forming process to form a film layer for forming a specific pattern, and then using the same mask plate to pattern the film layer through single patterning process. For example, two structural layers located in the same layer may be located on the same structural layer, or on different structural layers. Two structural layers located in the same layer might be at different heights or have different thicknesses.

In some embodiments, as shown in Fig. 1, the substrate structure 110 comprises a base substrate 111. The base substrate comprises a rigid substrate or a flexible substrate or the like. For example, the base substrate comprise a glass substrate or the like.

As shown in Fig. 1, the substrate structure 110 further comprises a light shielding layer 112 on the base substrate 111. An orthographic projection of the light shielding layer 112 on the base substrate 111 at least partially overlaps with an orthographic projection of the active layer 120 on the base substrate 111. For example, a material of the light shielding layer comprises a metal material such as aluminum, molybdenum, copper or the like.

As shown in Fig. 1, the substrate structure 110 further comprises a third conductive layer 113 covering the light shielding layer 112. The third conductive layer may extend from the light shielding layer 112 to the base substrate 111. The third conductive layer 113 may serve as another electrode plate of the capacitor.

It is to be noted that, in other embodiments, the positions of the light shielding layer 112 and the third conductive layer 113 may be interchanged. For example, the third conductive layer 113 is on the base substrate 111, and the light shielding layer 112 is on a side of the third conductive layer 113 away from the base substrate, that is, the light shielding layer covers the third conductive layer.

In some embodiments, a material of the third conductive layer 113 comprises a transparent conductive material. For example, the transparent conductive material comprises: ITO or IZO or the like. Here, the third conductive layer is made of the transparent conductive material, which can improve the light transmittance of the array substrate.

As shown in Fig. 1, the substrate structure 110 further comprises a buffer layer 114 between the third conductive layer 113 and the active layer 120. For example, the buffer layer comprises an inorganic insulating material such as silicon dioxide or the like. The buffer layer 114 covers the third conductive layer 113, the base substrate 111 and the like.

In some embodiments, as shown in Fig. 1, the base substrate 110 further comprises a wire 115. The first connection member 161 may be electrically connected to the wire 115 through a third through hole (as a conductive through hole) 143 passing through the first insulating layer 130 and the buffer layer 114. The wire 115 may be in a same layer as the light shielding layer 112. For example, a material of the wire 115 is the same as a material of the light shielding layer 112. The wire 115 is isolated from the light shielding layer 112.

In some embodiments, an orthographic projection of the first conductive layer 151 on the base substrate 111 at least partially overlaps with the orthographic projection of the light shielding layer 112 on the base substrate 111. The light shielding layer can product a light shielding effect.

In some embodiments, a thickness of the third conductive layer 113 is greater than a thickness of the second conductive layer 152. The thickness of the second conductive layer 152 is equal to a thickness of the first conductive layer 151. Thus, the second conductive layer is relatively thin, which can further improve the light transmittance of the array substrate. In addition, a thickness of the third conductive layer 113 is relatively large, which can reduce the resistance.

For example, the thickness of the third conductive layer 113 is 3000 angstroms to 5000 angstroms. For example, the thickness of the second conductive layer 152 (or the first conductive layer 151) is 500 angstroms to 1000 angstroms.

In some embodiments, the thickness of the first conductive layer 151 is greater than a thickness of the active layer 120. For example, the thickness of the active layer 120 is 300 angstroms to 500 angstroms.

In some embodiments, an area of an overlapping portion of the first connection member 161 and the first conductive layer 151 is less than an area of an overlapping portion of the second connection member 162 and the second conductive layer 151. Here, the area of the overlapping portion of the second connection member and the second conductive layer is relatively large, which can reduce the contact resistance.

In some embodiments, as shown in Fig. 1, the first insulating layer 130 comprises a gate insulating layer 131 below the gate 163.

As shown in Fig. 1, the active layer 120 comprises: a first conductor region 121 electrically connected to the first connection member 161, a second conductor region 122 electrically connected to the second connection member 162, and a channel region 123 between the first conductor region 121 and the second conductor region 122. The channel region 123 is flush with an edge of the gate insulating layer 131. Here, the first conductive layer 151 is in contact with the first conductor region 121, and the second conductive layer 152 is in contact with the second conductor region 122. By making both sides of the channel region of the active layer conductive, it is possible to reduce the contact resistance between the first conductive layer and the active layer and the contact resistance between the second conductive layer and the active layer, which facilitates the transmission of current and improves the performance of the array substrate and the display apparatus formed by the array substrate.

Fig. 3 is an enlarged schematic view schematically showing the array substrate in Fig. 1 at block 201.

As shown in Fig. 3, the first conductive layer 151 comprises a first portion 1511 away from the gate 163 and a second portion 1512 close to the gate 163. The first portion 1511 is completely covered by the first connection member 161, and the second portion 1512 is not covered by the first connection member 161.

In some embodiments, as shown in Fig. 3, a width d1 of an overlapping portion of the first connection member 161 and the first conductive layer 151 along a direction from the first connection member 161 to the gate 163 is less than a distance d4 between an edge of the first conductive layer 151 and the channel region 123.

In some embodiments, an area of the first conductor layer 151 is greater than an area of an overlapping portion of the first connection member 161 and the first conductive layer 151 (that is, the portion corresponding to the width d1). This is conductive to adequate contact between the first connection member and the first conductive layer and prevents the problem of poor contact.

In some embodiments, an area of the first conductor layer 151 is less than an area of the channel region 123. The area of the channel region is relatively large, which is conductive to improve the performance of the thin film transistor.

It is to be noted that, the ""area" described in the present disclosure refers to an area of a surface of a structural layer parallel to a plane where the substrate is situated. For example, the area may be an area of an upper surface of the structural layer. For example, an area of an upper surface of the first conductor layer 151 is the area of the first conductor layer 151; and an area of an upper surface of the channel region 123 is the area of the channel region 123, and so forth.

In some embodiments, a distance d3 between the first conductive layer 151 and the gate 163 is greater than a width d1 of an overlapping portion of the first connection member 161 and the first conductive layer 151 along a direction from the first connection member to the gate, and the width d1 of the overlapping portion of the first connection member 161 and the first conductive layer 151 along the direction from the first connection member to the gate is greater than a width d2 of the second portion of the first conductive layer 151 (that is, the portion not covered by the first connection member 161) along the direction from the first connection member to the gate. That is, d3> d1> d2. Such size design is conducive to improving the performance of the thin film transistor, thereby improving the performance of the array substrate and the display apparatus formed by the array substrate.

As shown in Fig. 3, there is a gap 301 between the first conductive layer 151 and the gate insulating layer 131.

Returning to Fig. 1, in some embodiments, the array substrate further comprises a second insulating layer 171 covering the first connection member 161, the second connection member 162 and the gate 163. For example, a material of the second insulating layer 171 comprises at least one of silicon dioxide, silicon nitride or the like.

As shown in Fig. 1, the array substrate further comprises a planarization layer 172 on a side of the second insulating layer 171 away from the substrate structure 110. For example, a material of the planarization layer comprises an organic insulating material such as resin or the like.

As shown in Fig. 1, the array substrate further comprises a first electrode layer 181 and a pixel defining layer 174 on a side of the planarization layer 172 away from the substrate structure 110. The first electrode layer 181 is electrically connected to the second connection member 162 (for example, through a conductive through hole). The pixel defining layer 174 is provided with a first opening 1742 exposing at least a portion of the first electrode layer 181. For example, the first electrode layer is an anode layer. For example, a material of the first electrode layer 181 comprises a metal such as copper, silver, aluminum, aluminum alloy or the like, or a transparent conductive material such as ITO, IZO or the like.

As shown in Fig. 1, the array substrate further comprises a light emitting layer 180 at least located in the first opening 1742. The light emitting layer may comprise: a light emitting layer for emitting red light, a light emitting layer for emitting green light or a light emitting layer for emitting blue light.

As shown in Fig. 1, the array substrate further comprises a second electrode layer 182 electrically connected to the light emitting layer 180. The second electrode layer 182 covers the pixel defining layer 174 and the light emitting layer 180. The second electrode layer may be a cathode layer. For example, a material of the second electrode layer 182 comprises a metal such as copper, silver, aluminum, aluminum alloy or the like, or a transparent conductive material such as ITO, IZO or the like.

In some embodiments, the array substrate further comprises another functional layer between the first electrode layer 181 and the second electrode layer 182, for example, an electron transport layer, a hole transport layer, an electron blocking layer, a hole blocking layer, or the like. Therefore, the scope of the present disclosure is not limited thereto.

In some embodiments, as shown in Fig. 1, a width of an overlapping portion between an orthographic projection of the second conductive layer 152 on the base substrate 111 and an orthographic projection of the third conductive layer 113 on the base substrate 111 along the direction from the first connection member to the gate is less than a width of an overlapping portion between the orthographic projection of the second conductive layer 152 on the base substrate 111 and the orthographic projection of the first electrode layer 181 on the base substrate 111 along the direction from the first connection member to the gate. This is beneficial to improve the light transmittance of the array substrate.

In some embodiments, as shown in Fig. 1, the width of an overlapping portion between the orthographic projection of the second conductive layer 152 on the base substrate 111 and the orthographic projection of the third conductive layer 113 on the base substrate 111 along the direction from the first connection member to the gate is less than a width of an overlapping portion between the orthographic projection of the third conductive layer 113 on the base substrate 111 and the orthographic projection of the first electrode layer 181 on the base substrate 111 along the direction from the first connection member to the gate. This is beneficial to improve the light transmittance of the array substrate.

The present disclosure provides an array substrate. As shown in Fig. 1, the array substrate comprises: a substrate structure 110 and a thin film transistor on the substrate structure 110.

The thin film transistor comprises an active layer 120 on the substrate structure 110. The thin film transistor further comprises a patterned first insulating layer 130 on a side of the active layer 120 away from the substrate structure. The first insulating layer 130 is provided with a first through hole 141 exposing a portion of the active layer 120. The thin film transistor further comprises a first conductive layer 151 in the first through hole 141 and in contact with the active layer 120. The thin film transistor further comprises a first connection member 161, a second connection member 162 and a gate 163 which are on a side of the first insulating layer 130 away from the substrate structure. The first connection member 161 is in contact with the first conductive layer 151. The first connection member 161, the second connection member 162 and the gate 163 are in a same layer and isolated from each other. The gate 163 is between the first connection member 161 and the second connection member 162.

As shown in Figs. 1 and 3, the active layer 120 comprises: a first conductor region 121 electrically connected to the first connection member 161, a second conductor region 122 electrically connected to the second connection member 162, and a channel region 123 between the first conductor region 121 and the second conductor region 122. The channel region 123 is below the gate 163.

As shown in Fig. 3, the first conductive layer 151 comprises a first portion 1511 away from the gate 163 and a second portion 1512 close to the gate 163. The first portion 1511 is completely covered by the first connection member 161, and the second portion 1512 is not covered by the first connection member 161. An orthographic projection of the first conductive layer 151 on the substrate structure 110 is inside an orthographic projection of the active layer 120 on the substrate structure 110.

In the above-described embodiment, since the first conductive layer is formed in the first through hole of the first insulating layer, during the manufacturing process, the first conductive layer can protect a portion of the active layer below the first conductive layer to a certain extent, thereby reducing the possibility that the active layer has a missing portion, and further improving the performance of the array substrate and the display apparatus formed by the array substrate.

In some embodiments, as shown in Fig. 3, a width d2 of the second portion 1512 along a direction from the first connection member to the gate is less than a width d1 of the first portion 1511 along the direction from the first connection member to the gate. Here, the width of the first portion 1511 is equal to a width of an overlapping portion of the first connection member 161 and the first conductive layer 151, both d1.

For example, the width d1 of the first portion 1511 is 2 to 5 times the width d2 of the second portion 1512.

In some embodiments, as shown in Fig. 3, the width d2 of the second portion 1512 along the direction from the first connection member to the gate is less than a width d5 of the channel region 123 along the direction from the first connection member to the gate.

In some embodiments, as shown in Fig. 3, a thickness H2 of the second portion 1512 is less than a thickness H1 of the first portion 1511.

In some embodiments, as shown in Figs. 1 and 3, the active layer 120 further comprises a semiconductor region (which may be referred to as a first semiconductor region) 124. The semiconductor region 124 is on a side of the first conductor region 121 away from the channel region 123. The width d2 of the second portion 1512 along the direction from the first connection member to the gate is less than a width d6 of the semiconductor region 124 along the direction from the first connection member to the gate.

In other embodiments, the active layer further comprises another semiconductor region, which may be referred to as a second semiconductor region (not shown in the drawing). The second semiconductor region is on a side of the second conductor region 122 away from the channel region 123.

Fig. 2 is a schematic cross-sectional view showing an array substrate according to another embodiment of the present disclosure.

A structure of the array substrate shown in Fig. 2 is similar to a structure of the array substrate shown in Fig. 1. Different from the structure of the array substrate shown in Fig. 1, in the array substrate shown in Fig. 2, the second through hole 142 further exposes a portion of the buffer layer 114, and the second conductive layer 152 comprises: a third portion 1521 on a surface of the active layer 120 and a fourth portion 1522 on a surface of the buffer layer 114. For example, in the structure shown in Fig. 2, a transverse dimension of the active layer 120 is less than a transverse dimension of the active layer in Fig. 1, and an area of the third portion of the second conductive layer 152 is less than an area of an overlapping portion of the second conductive layer and the active layer in Fig. 1. Therefore, in the array substrate shown in Fig. 2, an area of an overlapping portion of the second conductive layer and the active layer is reduced, which can improve the light transmittance of the array substrate.

Fig. 4 is a top view schematically showing a partial structure of an array substrate according to an embodiment of the present disclosure.

For convenience of illustration, Fig. 4 shows the first conductor region 121, the first conductive layer 151 and the first connection member 161 of the active layer of the array substrate. As shown in Fig. 4, due to the presence of the first conductive layer 151, the first conductor region 121 is not present with a missing portion, so that the current can flow relatively evenly through the first conductor region 121 from the first connection member, which improves the signal transmission capability of the array substrate.

In some embodiments of the present disclosure, a display apparatus is also provided, which comprises the array substrate as described previously, for example, the array substrate shown in Fig. 1 or 2. For example, the display apparatus may be: any product or member having a display function such as a display panel, a mobile phone, a tablet computer, a television, a display, a notebook computer, a digital photo frame or a navigator.

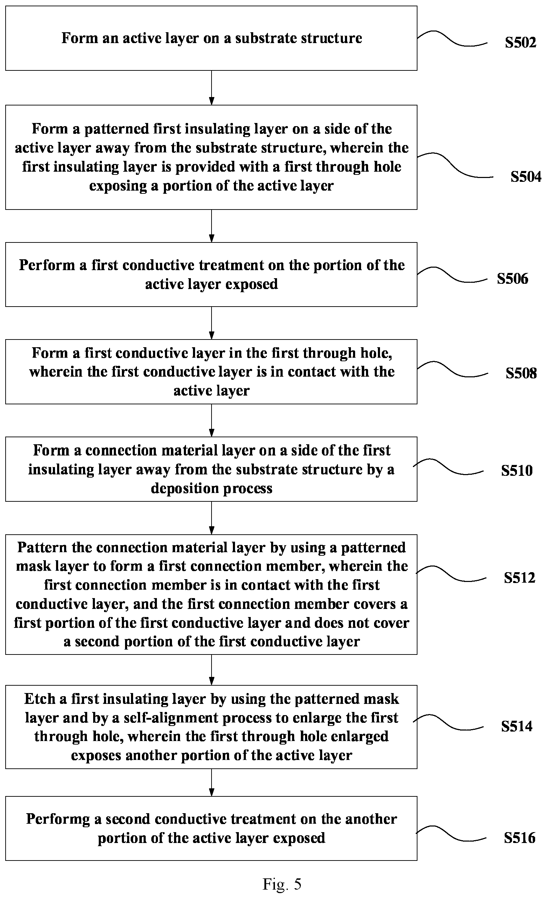

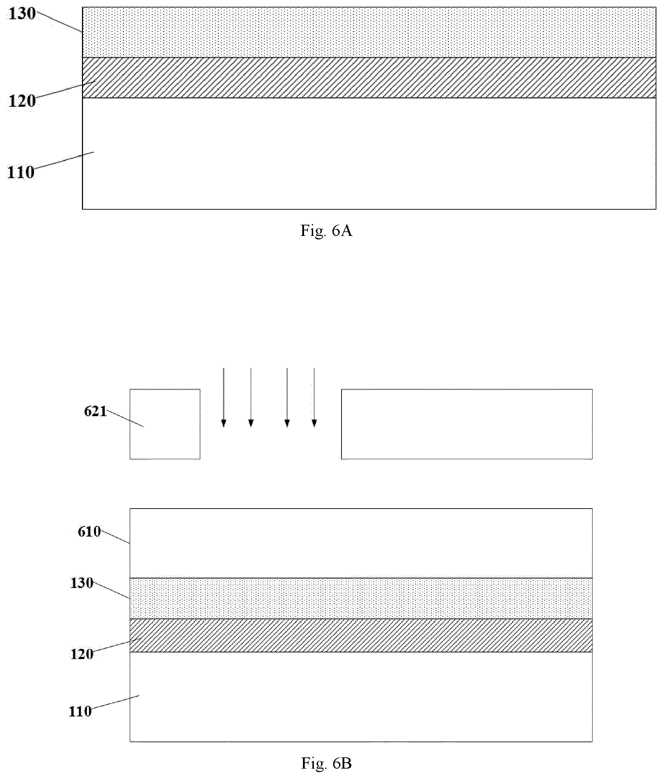

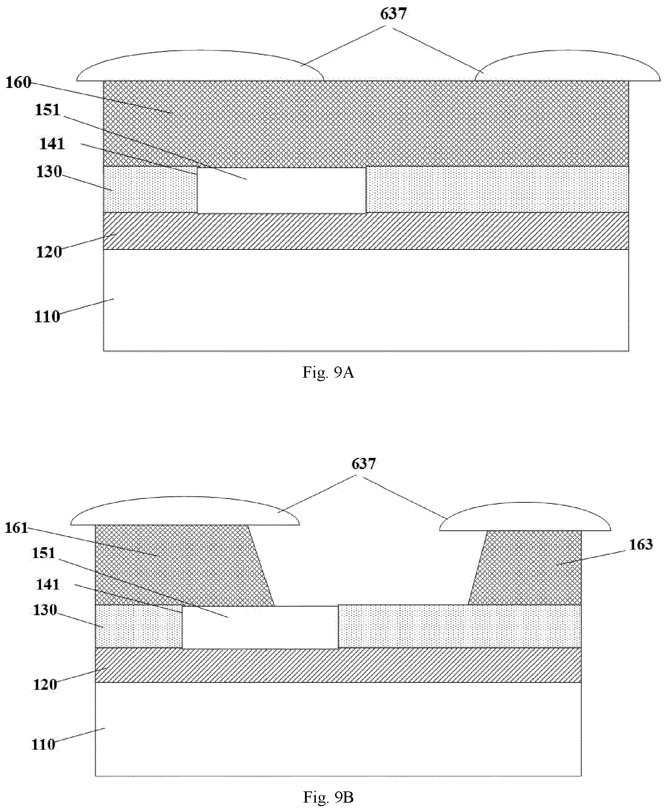

Fig. 5 is a flow chart showing a manufacturing method for an array substrate according to an embodiment of the present disclosure. As shown in Fig. 5, the manufacturing method comprises steps S502 to S508. Figs. 6A to 6I are schematic cross-sectional views showing structures at several stages during a manufacturing process of an array substrate according to some embodiments for the present disclosure. Figs. 9A to 9C are schematic cross-sectional views showing structures at several stages during a manufacturing process for an array substrate according to other embodiments of the present disclosure. The manufacturing process for the array substrate according to some embodiments of the present disclosure will be described in detail in conjunction with Figs. 5, 6A to 6I and Figs. 9A to 9C.

As shown in Fig. 5, in Step S502, an active layer is formed on a substrate structure.

For example, as shown in Fig. 6A, an active layer 120 is formed on a substrate structure 110, for example, by a deposition process. The specific structure of the substrate structure 110 has been described in detail previously, which will not be described in detail here.

Returning to Fig. 5, in Step S504, a patterned first insulating layer is formed on a side of the active layer away from the substrate structure, wherein the first insulating layer is provided with a first through hole exposing a portion of the active layer.

For example, a process of forming a patterned first insulating layer may be described in detail with reference to Figs. 6A to 6F.

As shown in Fig. 6A, a first insulating layer 130 is formed on a side of the active layer 120 away from the substrate structure 110, for example, by a deposition process.

Next, as shown in Fig. 6B, a first mask layer 610 is formed on a side of the first insulating layer 130 away from the substrate structure 110. For example, a material of the first mask layer is positive photoresist.

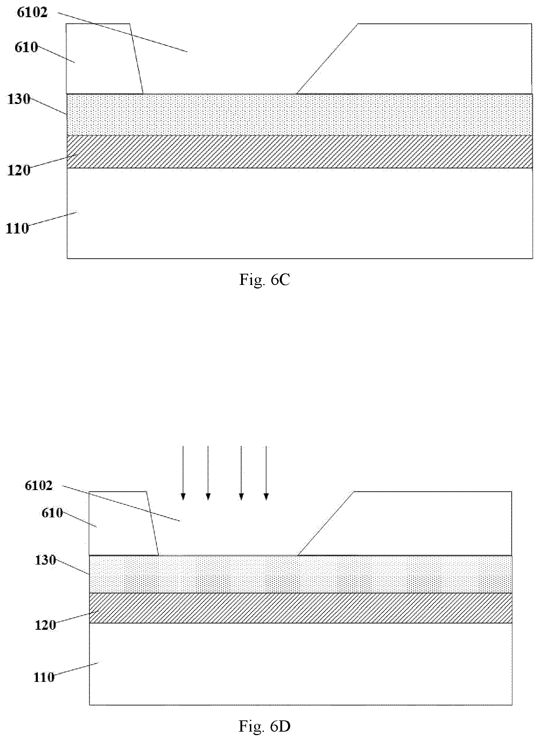

Next, as shown in Figs. 6B and 6C, the first mask layer 610 is patterned by using a patterned first mask plate 621, for example, by exposure and development techniques to form a patterned first mask layer 610, so that the patterned first mask layer comprises is provided with a second opening 6102 exposing a portion of the first insulating layer 130.

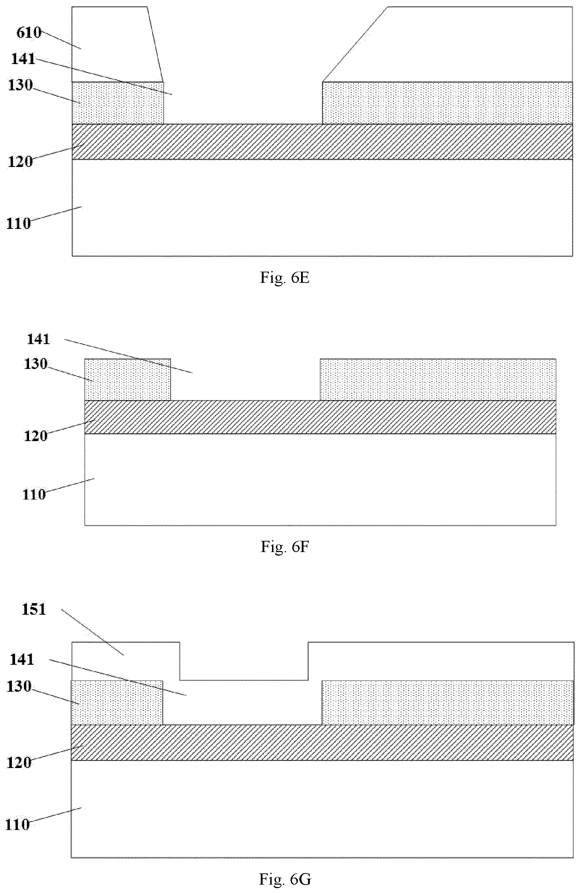

Next, as shown in Figs. 6D and 6E, the portion of the first insulating layer 130 exposed by the second opening 6102 is removed using the patterned first mask layer 610, by an etching process (for example, dry etching) to form a first through hole 141, thereby forming the patterned first insulating layer 130. The first through hole 141 exposes a portion of the active layer 120.

Returning to Fig. 5, in Step S506, a first conductive treatment is performed on the portion of the active layer exposed.

For example, as shown in Fig. 6E, a first conductive treatment is performed on the exposed portion of the active layer 120. For example, the first conductive treatment is performed by a dry etching process and by using He gas (helium gas).

Next, as shown in Fig. 6F, the first mask layer 610 is removed.

Returning to Fig. 5, in Step S508, a first conductive layer is formed in the first through hole, wherein the first conductive layer is in contact with the active layer.

For example, the process of forming the first conductive layer can be described in detail with reference with Figs. 6G to 6I.

For example, as shown in Fig. 6G, a first conductive layer 151 is formed on a side of the patterned first insulating layer 130 away from the substrate structure 110 and in the first through hole 141 by a deposition process. For example, a material of the first conductive layer 151 comprises a transparent conductive material.

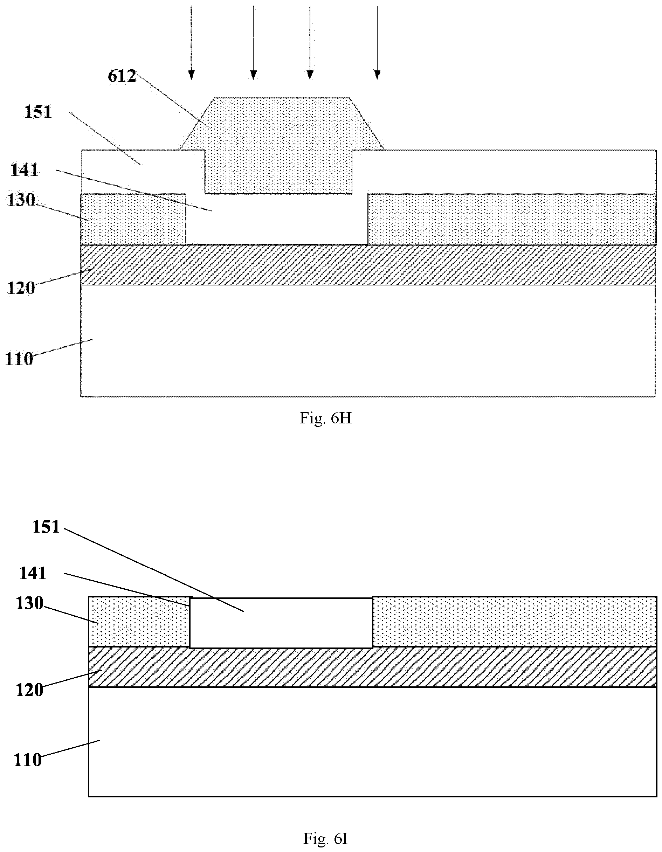

Next, as shown in Fig. 6H, a second mask layer 612 is formed on a side of the first conductive layer 151 away from the substrate structure 110, and the second mask layer 612 is exposed and developed using the first mask plate 621 described previously, thereby forming a structure of the second mask layer 612 shown in Fig. 6H. For example, a material of the second mask layer is negative photoresist.

Next, as shown in Fig. 6H, the first conductive layer 151 is etched to remove a portion of the first conductive layer 151 that is not covered by the second mask layer 612, and to retain a portion of the first conductive layer 151 that is covered by the second mask layer 612, thereby forming a structure shown in Fig. 6I.

Next, as shown in Fig. 6I, the second mask layer 612 is removed.

So far, the patterned first conductive layer 151 is formed, wherein the first conductive layer 151 can protect the active layer 120 below the first conductive layer 151 from being etched as much as possible.

Returning to Fig. 5, in Step S510, a connection material layer is formed on a side of the first insulating layer away from the substrate structure by a deposition process.

For example, as shown in Fig. 9A, a connection material layer 160 is formed on a side of the first insulating layer 130 away from the substrate structure 110 by a deposition process. A material of the connection material layer 160 comprises a metal such as copper or the like.

Returning to Fig. 5, in Step S512, the connection material layer is patterned by using a patterned mask layer to form a first connection member, wherein the first connection member is in contact with the first conductive layer, and the first connection member covers a first portion of the first conductive layer and does not cover a second portion of the first conductive layer.

For example, as shown in Fig. 9A, a patterned mask layer (which may be referred to as a third mask layer) 637 is formed on a side of the connection material layer away from the substrate structure 110. For example, a material of the third mask layer is photoresist.

Next, as shown in Fig. 9B, for example, the connection material layer 160 is patterned by using the third mask layer 637, by a wet etching process, to form the first connection member 161. In addition, a second connection member 162, a gate 163 and the like can be formed during the process. During the wet etching process, an etching liquid might etch a portion of the connection material layer below an edge of the third mask layer, so that the formed first connection member is recessed inward.

In this way, the first connection member is formed.

Returning to Fig. 5, in Step S514, the first insulating layer is etched by using the patterned mask layer and by a self-alignment process to enlarge the first through hole, wherein the first through hole enlarged exposes another portion of the active layer.

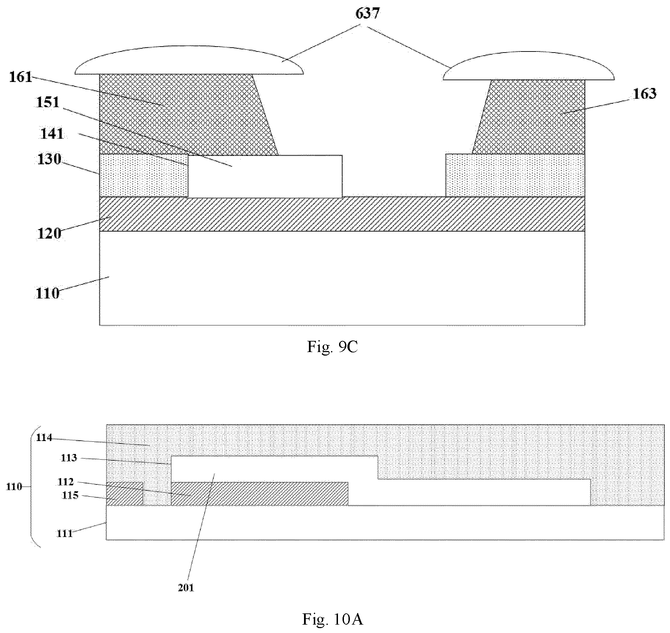

For example, as shown in Fig. 9C, the first insulating layer 130 is etched using the patterned mask layer (that is, the third mask layer) 637 by a self-alignment process to enlarge the first through hole 141, wherein the first through hole 141 enlarged exposes another portion of the active layer 120. For example, the etching is dry etching. Here, the entire surface of the first insulating layer is etched to form a gap between the first conductive layer and the gate insulating layer, that is, the gap 301 described previously.

Returning to Fig. 5, in Step S516, a second conductive treatment is performed on the another portion of the active layer exposed.

For example, as shown in Fig. 9C, a second conductive treatment is performed on the exposed another portion of the active layer 120 . For example, the second conductive treatment is performed by a dry etching process and by using He gas (helium gas). During the process, due to the presence of the first conductive layer 151, the portion of the active layer directly below the first conductive layer 151 can be protected from being etched.

Next, the third mask layer 637 is removed.

So far, the manufacturing method for an array substrate according to some embodiments of the present disclosure is provided. The manufacturing method comprises: forming an active layer on a substrate structure; forming a patterned first insulating layer on a side of the active layer away from the substrate structure, wherein the first insulating layer is provided with a first through hole exposing a portion of the active layer; performing a first conductive treatment on the portion of the active layer exposed; forming a first conductive layer in the first through hole, wherein the first conductive layer is in contact with the active layer; forming a connection material layer on a side of the first insulating layer away from the substrate structure by a deposition process; patterning the connection material layer by using a patterned mask layer to form a first connection member, wherein the first connection member is in contact with the first conductive layer, and the first connection member covers a first portion of the first conductive layer and does not cover a second portion of the first conductive layer; etching a first insulating layer by using the patterned mask layer and by a self-alignment process to enlarge the first through hole, wherein the first through hole enlarged exposes another portion of the active layer; and performing a second conductive treatment on the another portion of the active layer exposed. The manufacturing method can reduce the possibility that the active layer is present with a missing portion, and further improve the performance of the array substrate and the display apparatus formed by the array substrate.

Further, in the above-described manufacturing process, the second mask layer uses negative photoresist, so that exposure and development can be performed by using the first mask plate described previously, without additionally manufacturing a mask plate, thereby reducing the process complexity.

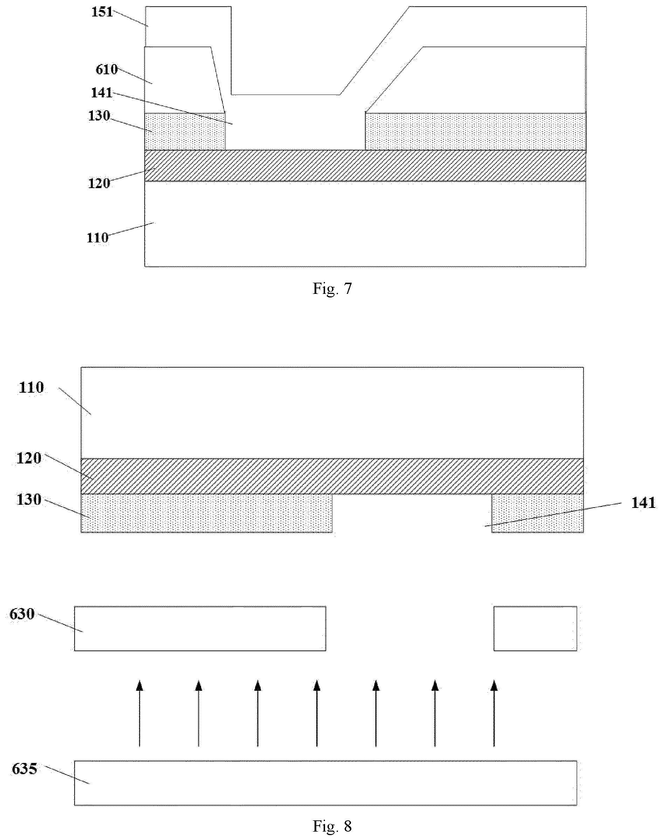

Fig. 7 is a schematic cross-sectional view showing a structure at one stage during a manufacturing process for an array substrate according to another embodiment of the present disclosure. Fig. 7 shows a schematic cross-sectional view of a structure at one stage during the process of forming a first conductive layer according to other embodiments.

For example, as shown in Fig. 7, after the structure shown in Fig. 6E is formed, a first conductive layer 151 is formed on the patterned first mask layer 610 and in the first through hole 141 of the first insulating layer 130 by a deposition process.

Next, by a lift-off process, the first mask layer 610 and the portion of the first conductive layer 151 on the first mask layer 610 is removed, and the portion of the first conductive layer 151 in the first through hole 141 is retained, thereby forming a structure as shown in Fig. 6I.

In the embodiment, the lift-off process is used, without adding an additional masking process, thereby further reducing the process complexity.

Fig. 8 is a schematic cross-sectional view showing a structure at one stage during a manufacturing process for an array substrate according to another embodiment of the present disclosure. Fig. 8 shows a schematic cross-sectional view of a structure at one stage during the process of forming a first conductive layer according to other embodiments.

For example, as shown in Fig. 8, after the structure shown in Fig. 6F is formed, the first conductive layer 151 is formed in the first through hole 141 of the first insulating layer 130 using the patterned second mask 630 by an evaporation process, that is, the structure shown in Fig. 6I is formed. As shown in Fig. 8, the second mask plate 630 is provided with a through hole (which may be referred to as a fourth through hole), and the opening is aligned with the first through hole 141. For example, the second mask is an FMM mask plate (Fine Metal Mask). In addition, Fig. 8 further shows an evaporation source 635. A material of the evaporation source comprises a transparent conductive material (for example, ITO, IZO or the like).

In the embodiment, the first conductive layer is formed by the evaporation process, which can reduce the process complexity.

Figs. 10A to 10C are schematic cross-sectional views showing structures at several stages during a manufacturing process for an array substrate according to other embodiments of the present disclosure. Next, a manufacturing process for an array substrate according to other embodiments of the present disclosure will be described in detail in conjunction with Figs. 10A to 10C and Fig. 1.

First, as shown in Fig. 10A, a substrate structure is provided. The step of providing the substrate structure comprises the following steps.

For example, as shown in Fig. 10A, a light shielding layer 112 is formed on a base substrate 111 by a deposition process and a patterning process. In addition, a wire 115 is also formed.

Next, as shown in Fig. 10A, a third conductive layer 113 covering the light shielding layer 112 is formed by a deposition process and a patterning process.

In other embodiments, the third conductive layer 113 may also be first formed on the base substrate 111 by a deposition process and a patterning process. Then, the light shielding layer 112 is formed on the third conductive layer 113 by a deposition process and a patterning process.

Next, as shown in Fig. 10A, a buffer layer 114 covering the third conductive layer 113 is formed by a deposition process.

So far, the substrate structure 110 is formed.

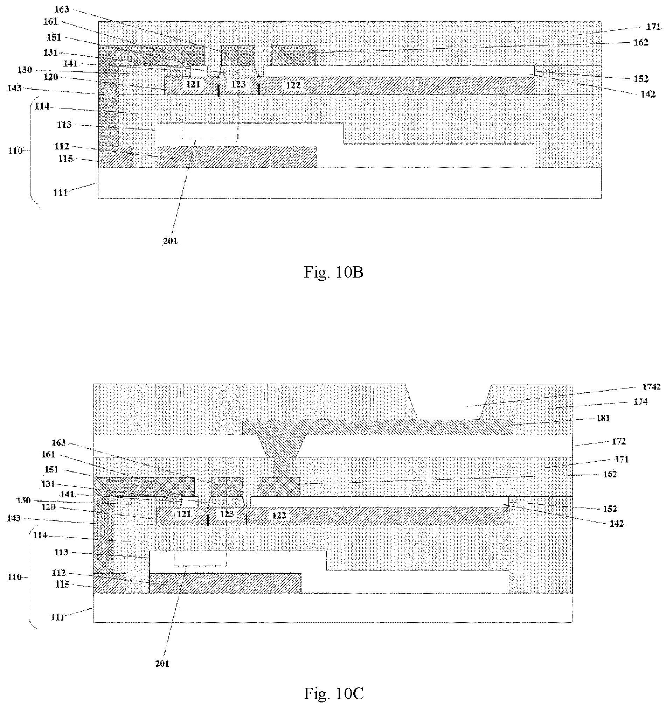

Next, as shown in Fig. 10B, an active layer 120, a first insulating layer 130, a first through hole 141, a first conductive layer 151 and a first connection member 161 are formed by the process described above. Here, a second through hole 142, a third through hole 143, a second conductive layer 152, a second connection member 162 and a gate 163 are also formed.

It is to be noted that, the second conductive layer 152 is formed by a same process as the first conductive layer 151, and the second connection member 162 and the gate 163 are formed by a same patterning process as the first connection member 161, which will not be described in detail here.

It is also to be noted that, the second through hole 142 and the third through hole 143 may also be formed at the same time when the first through hole 141 is formed. Forming processes of the second through hole 142 and the third through hole 143 is similar to a forming process of the first through hole 141, which will not be described in detail here.

Next, as shown in Fig. 10B, a second insulating layer 171 covering the first connection member 161, the second connection member 162 and the gate 163 is formed by a deposition process.

Next, as shown in Fig. 10C, a planarization layer 172 is formed on a side of the second insulating layer 171 away from the substrate structure 110.

Next, as shown in Fig. 10C, a first electrode layer 181 is formed on a side of the planarization layer 172 away from the substrate structure 110, wherein the first electrode layer 181 is electrically connected to the second connection member 162.

Next, as shown in Fig. 10C, a pixel defining layer 174 is formed on a side of the planarization layer 172 away from the substrate structure 110. The pixel defining layer 174 is provided with a first opening 1742 exposing at least a portion of the first electrode layer 181.

Next, as shown in Fig. 1, a light emitting layer 180 at least located in the first opening 1742 is formed.

Next, as shown in Fig. 1, a second electrode layer 182 is formed by a deposition process, wherein the second electrode layer 182 is electrically connected to the light emitting layer 180.

So far, a manufacturing method for an array substrate according to some embodiments of the present disclosure is provided. The manufacturing method can reduce the possibility that the active layer is present with a missing portion, and further improve the performance of the array substrate and the display apparatus formed by the array substrate.

Hereto, various embodiments of the present disclosure have been described in detail. Some details well known in the art are not described in order to avoid obscuring the concept of the present disclosure. According to the above description, those skilled in the art would fully understand how to implement the technical solutions disclosed here.

Although some specific embodiments of the present disclosure have been described in detail by way of examples, those skilled in the art should understand that the above examples are only for an illustrative purpose, rather than limiting the scope of the present disclosure. It should be understood by those skilled in the art that modifications to the above embodiments or equivalent replacements to some technical features may be made without departing from the scope and spirit of the present disclosure. The scope of the present disclosure is defined by the appended claims.

## Claims

1. An array substrate, comprising:
a substrate structure;
an active layer on the substrate structure;
a first insulating layer on a side of the active layer away from the substrate structure, wherein the first insulating layer is patterned and the first insulating layer is provided with a first through hole exposing a portion of the active layer;
a first conductive layer in the first through hole and in contact with the active layer; and
a first connection member on a side of the first insulating layer away from the substrate structure, wherein the first connection member is in contact with the first conductive layer, and the first connection member covers a first portion of the first conductive layer and does not cover a second portion of the first conductive layer.

2. The array substrate according to claim 1, wherein:
the first insulating layer is further provided with a second through hole exposing another portion of the active layer; and
the array substrate further comprises:
a second conductive layer in the second through hole;
a second connection member electrically connected to the second conductive layer; and
a gate on a side of the first insulating layer away from the active layer;
wherein the second connection member is in a same layer as the gate, and the first connection member and the second connection member are isolated from the gate.

3. The array substrate according to claim 2, wherein the substrate structure comprises:
a base substrate;
a light shielding layer and a third conductive layer on the base substrate, wherein an orthographic projection of the light shielding layer on the base substrate at least partially overlaps with an orthographic projection of the active layer on the base substrate, wherein the third conductive layer covers the light shielding layer, or the light shielding layer covers the third conductive layer; and
a buffer layer between the third conductive layer and the active layer.

4. The array substrate according to claim 3, wherein an orthographic projection of the first conductive layer on the base substrate at least partially overlaps with the orthographic projection of the light shielding layer on the base substrate.

5. The array substrate according to claim 3, wherein:
the second through hole further exposes a portion of the buffer layer; and
the second conductive layer comprises: a third portion on a surface of the active layer and a fourth portion on a surface of the buffer layer.

6. The array substrate according to claim 3, wherein materials of the first conductive layer, the second conductive layer and the third conductive layer comprise a transparent conductive material.

7. The array substrate according to claim 3, wherein a thickness of the third conductive layer is greater than a thickness of the second conductive layer, and the thickness of the second conductive layer is equal to a thickness of the first conductive layer.

8. The array substrate according to claim 1, wherein a thickness of the first conductive layer is greater than a thickness of the active layer.

9. The array substrate according to claim 2, wherein an area of an overlapping portion of the first connection member and the first conductive layer is less than an area of an overlapping portion of the second connection member and the second conductive layer.

10. The array substrate according to claim 3, wherein:
the first insulating layer comprises a gate insulating layer below the gate; and
the active layer comprises: a first conductor region electrically connected to the first connection member, a second conductor region electrically connected to the second connection member, and a channel region between the first conductor region and the second conductor region, wherein the channel region is flush with an edge of the gate insulating layer.

11. The array substrate according to claim 10, wherein a width of an overlapping portion of the first connection member and the first conductive layer along a direction from the first connection member to the gate is less than a distance between an edge of the first conductive layer and the channel region.

12. The array substrate according to claim 1, wherein an area of the first conductor layer is greater than an area of an overlapping portion of the first connection member and the first conductive layer.

13. The array substrate according to claim 10, wherein an area of the first conductor layer is less than an area of the channel region.

14. The array substrate according to claim 2, wherein a width of an overlapping portion of the first conductive layer and the active layer along a direction from the first connection member to the gate is less than a width of an overlapping portion of the second conductive layer and the active layer along the direction from the first connection member to the gate.

15. The array substrate according to claim 2, wherein:
a distance between the first conductive layer and the gate is greater than a width of an overlapping portion of the first connection member and the first conductive layer along a direction from the first connection member to the gate, and the width of the overlapping portion of the first connection member and the first conductive layer along the direction from the first connection member to the gate is greater than a width of the second portion of the first conductive layer along the direction from the first connection member to the gate.

16. The array substrate according to claim 3, further comprising:
a second insulating layer covering the first connection member, the second connection member and the gate;
a planarization layer on a side of the second insulating layer away from the substrate structure;
a first electrode layer and a pixel defining layer on a side of the planarization layer away from the substrate structure, wherein the first electrode layer is electrically connected to the second connection member, and the pixel defining layer is provided with a first opening exposing at least a portion of the first electrode layer;
a light emitting layer at least located in the first opening; and
a second electrode layer electrically connected to the light emitting layer.

17. The array substrate according to claim 16, wherein a width of an overlapping portion between an orthographic projection of the second conductive layer on the base substrate and an orthographic projection of the third conductive layer on the base substrate along a direction from the first connection member to the gate is less than a width of an overlapping portion between the orthographic projection of the second conductive layer on the base substrate and an orthographic projection of the first electrode layer on the base substrate along the direction from the first connection member to the gate.

18. The array substrate according to claim 16, wherein a width of an overlapping portion between an orthographic projection of the second conductive layer on the base substrate and an orthographic projection of the third conductive layer on the base substrate along a direction from the first connection member to the gate is less than a width of an overlapping portion between the orthographic projection of the third conductive layer on the base substrate and an orthographic projection of the first electrode layer on the base substrate along the direction from the first connection member to the gate.

19. An array substrate, comprising:
a substrate structure; and
a thin film transistor on the substrate structure, the thin film transistor comprising:
an active layer on the substrate structure;
a first insulating layer on a side of the active layer away from the substrate structure, wherein the first insulating layer is patterned and the first insulating layer is provided with a first through hole exposing a portion of the active layer;
a first conductive layer in the first through hole and in contact with the active layer; and
a first connection member, a second connection member and a gate on a side of the first insulating layer away from the substrate structure, wherein the first connection member is in contact with the first conductive layer, the first connection member, the second connection member and the gate are in a same layer and isolated from each other, and the gate is between the first connection member and the second connection member;
wherein the active layer comprises: a first conductor region electrically connected to the first connection member, a second conductor region electrically connected to the second connection member and a channel region between the first conductor region and the second conductor region, wherein the channel region is below the gate;
the first conductive layer comprises a first portion away from the gate and a second portion close to the gate, the first portion is completely covered by the first connection member, the second portion is not covered by the first connection member, and an orthographic projection of the first conductive layer on the substrate structure is inside an orthographic projection of the active layer on the substrate structure.

20. The array substrate according to claim 19, wherein a width of the second portion along a direction from the first connection member to the gate is less than a width of the first portion along the direction from the first connection member to the gate.

21. The array substrate according to claim 19, wherein a width of the second portion along a direction from the first connection member to the gate is less than a width of the channel region along the direction from the first connection member to the gate.

22. The array substrate according to claim 19, wherein a thickness of the second portion is less than a thickness of the first portion.

23. The array substrate according to claim 20, wherein the width of the first portion is 2 to 5 times the width of the second portion.

24. The array substrate according to claim 20, wherein the active layer further comprises a semiconductor region on a side of the first conductor region away from the channel region, wherein the width of the second portion along the direction from the first connection member to the gate is less than a width of the semiconductor region along the direction from the first connection member to the gate.

25. A display apparatus, comprising: the array substrate according to any of claims 1 to 24.

26. A manufacturing method for an array substrate, comprising:
forming an active layer on a substrate structure;
forming a first insulating layer on a side of the active layer away from the substrate structure, wherein the first insulating layer is patterned and the first insulating layer is provided with a first through hole exposing a portion of the active layer;
performing a first conductive treatment on the portion of the active layer exposed;
forming a first conductive layer in the first through hole, wherein the first conductive layer is in contact with the active layer;
forming a connection material layer on a side of the first insulating layer away from the substrate structure by a deposition process;
patterning the connection material layer by using a patterned mask layer to form a first connection member, wherein the first connection member is in contact with the first conductive layer, and the first connection member covers a first portion of the first conductive layer and does not cover a second portion of the first conductive layer;
etching a first insulating layer by using the patterned mask layer and by a self-alignment process to enlarge the first through hole, wherein the first through hole enlarged exposes another portion of the active layer; and
performing a second conductive treatment on the another portion of the active layer exposed.
